# DEMANDE DE BREVET EUROPEEN

(11) **EP 0 664 461 A1**
(43) Date de publication de la demande: **26.07.1995**
(21) Numéro de dépôt: 95420007.7
(22) Date de dépôt: 13.01.1995
(51) Int. Cl.: G01R 31/28, G01R 31/00, G07B 13/02

(54) **Procédé et dispositif de contrôle d'un capteur électronique équipant un véhicule automobile muni d'un système de freinage "anti-blocage-sécurité"**

(30) Priorité: 25.01.1994 FR 9401045
(71) Demandeur: Ricard, Claude, F-13100 Aix-en-Provence (FR)
(72) Inventeur: Ricard, Claude, F-13100 Aix-en-Provence (FR)
(74) Mandataire: Wind, Jacques

(57) **Abrégé**

Procédé et dispositif pour contrôler un capteur électronique (1) équipant un véhicule automobile muni d'un freinage ABS, dans le cas particulier ou un circuit électronique auxiliaire (13) est prévu entre ce capteur (1) et le fil d'entrée (8) du système ABS.

Un courant de test (I) est injecté dans le capteur (1) via une résistance de mesure (10). La tension (Vo) aux bornes de cette résistance est comparée (14) à un seuil. Si elle est inférieure à une valeur déterminée, elle déclenche, via un microprocesseur (23), l'ouverture d'un interrupteur commandé (7) placé en aval de ce circuit auxiliaire (13). Le microprocesseur (23) n'agit sur cet interrupteur (7) que s'il ne reçoit pas d'impulsions (4) en provenance du capteur. Le test habituel du capteur peut alors être normalement effectué par le système ABS.

## Description

La présente invention se rapporte à un procédé, et à un dispositif, pour permettre le contrôle d'un capteur électronique équipant un véhicule automobile muni d'un système de freinage "Anti-Blocage-Sécurité", dit "freinage ABS", dans le cas où un circuit électronique auxiliaire est inséré entre les fils de sortie de ce capteur et son câble habituel de connexion au système ABS.

Le demandeur a décrit, dans ses demandes de Brevet en France N° 93 04091 et 93 14273, respectivement déposées le 01 Avril 1993 et le 24 Novembre 1993, des adaptateurs électroniques pour véhicules automobiles équipés d'un taximètre ou d'un chronotachygraphe.

Pour chacun de ces adaptateurs, il est utilisé un amplificateur opérationnel de recopie du signal délivré par le capteur électronique du nombre de tours de roue, cet amplificateur étant connecté directement aux bornes de sortie du capteur.

Dans le cas d'un véhicule équipé d'un système de freinage ABS, la sortie de ce circuit électronique de recopie du signal du capteur est normalement connectée au circuit habituel de freinage ABS, qui est un circuit électronique fort complexe et comportant entre autres un dispositif de test de présence du capteur et de non-coupure de la liaison filaire existant normalement entre le capteur électronique et ce circuit ABS.

Ce dispositif de test mesure en fait périodiquement l'impédance d'entrée du capteur, vue du système ABS. Si cette impédance d'entrée est faible, il conclut à la présence correcte du capteur. Si au contraire cette impédance d'entrée est élevée, il conclut à la présence d'une coupure dans la connexion filaire qui le relie au capteur, ou à l'absence du capteur, et agit donc en conséquence.

Dans le cas de dispositifs, tels que ceux selon les demandes de Brevet FR 93.04091 et FR 93.14273 précitées, pour lesquels un circuit électronique auxiliaire est inséré entre le capteur et le système ABS, ce dernier va mesurer toujours une faible impédance en amont, même si la liaison filaire qui relie le capteur à ce circuit électronique auxiliaire est coupée ou si le capteur est absent, car en fait il va mesurer l'impédance de sortie de ce dispositif électronique auxiliaire, qui est toujours relativement faible quoi qu'il en soit.

L 'invention vise à remédier à cet inconvénient. Elle prévoit à cet effet d'injecter, sur un fil d'entrée de ce circuit électronique auxiliaire, un courant de test dans le capteur, de mesurer ce courant de test, et de couper la liaison filaire de sortie de ce circuit électronique auxiliaire au cas où ce courant est d'intensité inférieure à une valeur déterminée et en particulier caractéristique du fait qu'une liaison filaire directement associée à ce capteur est coupée ou du fait que ce capteur est absent.

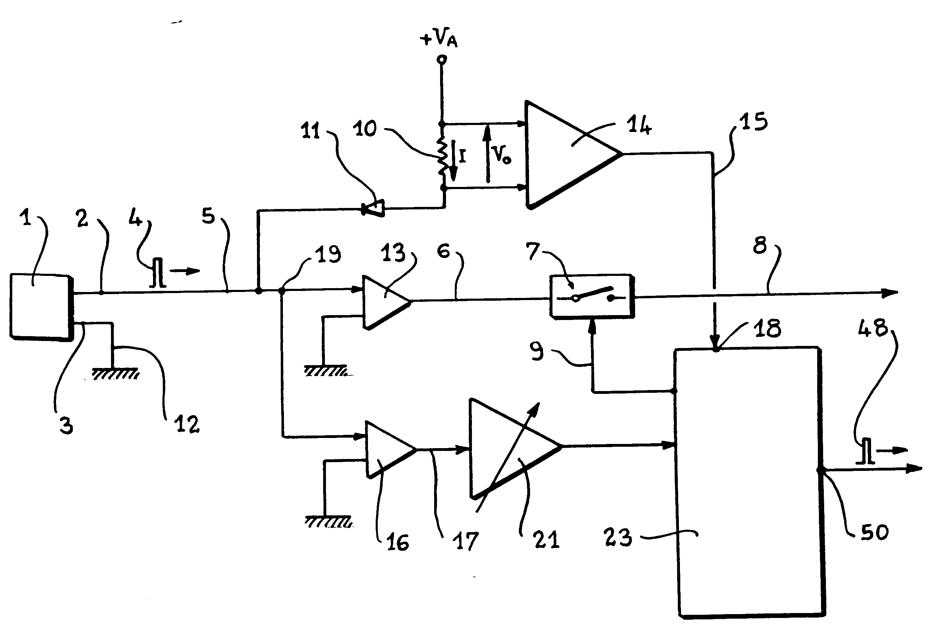

L'invention sera bien comprise, et ses avantages et autres caractéristiques ressortiront, lors de la description suivante d'un exemple non limitatif de réalisation, en référence au dessin schématique annexé qui est une figure unique donnant le schéma synoptique de cet exemple de réalisation.

En se référant à cette figure unique, la référence 1 désigne un capteur électronique du nombre de tours de roue effectué par un véhicule, qui dans cet exemple est supposé être un taxi équipé d'un taximètre non représenté.

Ce taxi étant équipé d'un système de freinage ABS, le capteur 1 est prévu sur une roue du véhicule. Il délivre, entre sa borne de sortie 2 et sa borne de masse 3, des impulsions électriques 4 dont le nombre est proportionnel au nombre de tours effectué par cette roue. Ces impulsions sont véhiculées sur le câble de sortie 5 du capteur.

De même façon qu'il est décrit dans les deux demandes de Brevet FR 93.04091 et FR 93.14273 précitées, les impulsions 4 véhiculées sur le câble 5 sont appliquées d'une part à un premier amplificateur opérationnel 13 de recopie approximative du signal 4 délivré par le capteur 1, cet amplificateur 13 constituant un élément unidirectionnel permettant d'éviter, comme il est expliqué dans la demande de Brevet FR 93.04091 précitée, un fraudage du taximètre, et elles sont appliquées d'autre part à un deuxième amplificateur opérationnel 16 qui constitue le préamplificateur de l'adaptateur électronique lié au taximètre.

La sortie 6 du premier amplificateur 13 alimente, via un interrupteur statique 7, un câble 8 qui est le très classique câble d'alimentation, en impulsions recopiées de celles 4 du capteur 1, du tableau de bord du véhicule ainsi que de son circuit d'ABS (non représentés).

Comme il est expliqué dans la demande FR 93.04091 précitée, les impulsions en sortie 17 du préamplificateur 16 sont appliquées à un amplificateur à gain réglable 21 qui est conçu pour délivrer, en réponse aux signaux d'entrée transmis sur le câble 5, des signaux à deux niveaux logiques à un organe logique de calcul et de commande 23, typiquement un microprocesseur.

Ce microprocesseur 23 comporte un diviseur de fréquence et il présente au moins une sortie 50 qui délivre, en réponse aux signaux qu il reçoit de l'amplificateur à gain réglable 21, des trains d'impulsions 48 qui sont représentatifs du nombre de tours de roue effectué par le véhicule.

Entre autres, le microprocesseur 23 commande aussi, via une liaison de commande 9, l'ouverture et la fermeture du relais statique 7.

Le relais statique 7 est un des éléments de la présente invention. Il pourrait bien entendu être remplacé par un autre type d'interrupteur commandé, tel qu'un relais à lames souples, ou "reed switch".

Le fil 5 de sortie du capteur 1 peut être coupé, soit accidentellement, soit dans un but frauduleux.

Dans un système classique, ce fil 5 serait relié directement au fil 8. On sait que tout système ABS teste périodiquement l'impédance du circuit placé en amont, c'est-à-dire classiquement le capteur 1 et ses fils de sortie 5 et 12. Si cette impédance est élevée, c'est que ces fils sont coupés ou que le capteur a été enlevé, et le système ABS réagit en conséquence, en se mettant par exemple hors-circuit tout en déclenchant une alarme. Si elle est faible au contraire, c'est que tout est normal.

La présence du circuit de recopie 13 fausse totalement ce test, car le système ABS va alors toujours "voir" une faible impédance en amont, que le capteur 1 soit présent ou non et que ses fils de sortie 5,12 soient normalement présents ou qu'ils soient sectionnés ou débranchés.

Pour remédier à ceci, l'invention prévoit d'injecter un courant de test à travers le capteur 1 et ses fils de sortie 5,12, et de tester la bonne circulation de ce courant à travers cet ensemble.

Il est en conséquence prévu de relier une borne positive d'alimentation en tension continue +Va au fil de sortie 5 du capteur, à proximité immédiate de l'entrée 19 des amplificateurs 13 et 16, à travers une résistance de mesure 10, ainsi qu'éventuellement une diode de protection 11.

Si le capteur 1 est bien en place et qu'aucune des connexions de sortie de ce capteur n'est sectionnée ou débranchée, il doit circuler un courant de test I, entre la borne +Va et la masse. à travers successivement la résistance 10, la diode 11, le fil 5, le capteur 1, et la connexion de masse 12.

Ce courant I se manifeste sous la forme d'une tension de mesure Vo aux bornes de la résistance 10.

Cette tension Vo est appliquée à un comparateur à seuil 14 qui est branché comme représenté aux bornes de la résistance de mesure 10.

Si la tension Vo est supérieure à une valeur de seuil Vs prédéterminée, le comparateur 14 applique sur sa sortie 15 un niveau logique "0". Dans le cas contraire, il applique sur cette sortie 15 un niveau logique "1".

Cette sortie 15 étant connectée à une entrée 18 du microprocesseur 23, un niveau logique "0" est donc transmis, via le fil 15, à ce microprocesseur si le capteur 1 est absent ou si ses fils de liaison 5 et 12 sont sectionnés ou débranchés, tandis qu'un niveau logique "1" est de même façon transmis à ce microprocesseur si tout est en bon ordre.

Afin que la mesure ne soit pas perturbée par les impulsions de tension 4 délivrées par le capteur, le microprocesseur 23 ne teste son entrée 18 que lorsque le véhicule est à l'arrêt ou, plus généralement, que lorsqu'il ne reçoit aucune impulsion 4 en provenance du capteur. S'il trouve sur cette entrée 18, un niveau logique "0", il commande, par la liaison 9, l'ouverture de l'interrupteur statique 7. Dans le cas contraire, il maintient fermé ce dernier.

L'ouverture de l'interrupteur statique 7 recrée alors artificiellement la coupure de circuit que le circuit d'ABS est normalement prévu pour tester.

Finalement, ce circuit d'ABS voit bien une coupure 7 en amont si le capteur ou ses connexions sont en défaut, malgré la présence de l'amplificateur de recopie 13.

Comme il va de soi, l'invention n'est pas limitée à l'exemple de réalisation qui vient d'être décrit. Elle s'applique bien au contraire aussi bien par utilisation de divers moyens équivalents ainsi qu'à d ' autres véhicules automobiles que des taxis.

## Revendications

1. Procédé de contrôle d'un capteur électronique (1) équipant un véhicule automobile muni d'un système de freinage ABS, dans le cas où un circuit électronique auxiliaire (13) est inséré entre les fils de sortie (2,12) de ce capteur et son câble habituel (8) de connexion au système ABS,
caractérisé en ce qu'il consiste à injecter, sur un fil d'entrée (5) de ce circuit électronique auxiliaire (13), un courant de test (I) dans le capteur (1), à mesurer (10,14) ce courant de test, et à couper (23,9,7) la liaison filaire (6,8) de sortie de ce circuit électronique auxiliaire (13) au cas ou le courant (I) est d'intensité inférieure à une valeur déterminée et en particulier caractéristique du fait qu'une liaison filaire (2,12) directement associée à ce capteur (1) est coupée ou du fait que ce capteur (1) est absent.

2. Dispositif pour la mise en oeuvre du procédé selon la revendication 1, caractérisé en ce qu'une alimentation (+Va) en tension continue est reliée à un fil de sortie (5) du capteur (1), à proximité immédiate de l'entrée (19) dudit circuit électronique auxiliaire (13), à travers une résistance de mesure (10), en ce qu'un comparateur à seuil (14) est branché aux bornes de cette résistance de mesure (10), et en ce que ce comparateur (14) déclenche un circuit (15,23,9) de commande d'ouverture d'un interrupteur commandé (7) qui est prévu sur la liaison filaire (6,8) qui relie la sortie dudit circuit électronique auxiliaire (13) au système ABS qui équipe le véhicule, ce déclenchement étant réalisé lorsque la tension aux bornes de cette résistance (10) est inférieure à ladite valeur prédéterminée.

3. Dispositif selon la revendication 2, caractérisé en ce que ledit circuit de commande d'ouverture comprend un organe logique de commande et de calcul, tel qu'un microprocesseur (23), qui ne prend en charge le résultat de la mesure effectuée par ledit comparateur (14) que lorsqu'il ne reçoit pas d'impulsions (4) en provenance dudit capteur (1).
